# EUROPEAN PATENT APPLICATION

(11) **EP 4 557 570 A1**
(43) Date of publication of application: **21.05.2025**
(21) Application number: 24204997.1
(22) Date of filing: 07.10.2024
(51) Int. Cl.: H02J 7/32, E03B 7/07, H02N 2/18

(54) **SMART WATER VALVE CHARGED BY WATER FLOW**

(30) Priority: 16.10.2023 US 202318380650
(71) Applicant: Roku, Inc., San Jose, CA 95110 (US)
(72) Inventor: SASSENRATH, Carl, Reno (US); STERN, David, San Jose (US); GARNER, Greg, Key Colony Beach (US)
(74) Representative: Aldridge, Henry Alexander

(57) **Abstract**

An example apparatus includes a smart water valve device. The smart water valve device includes a controller. The smart water valve device also includes a water valve configured to regulate water flow from a pressurized water source and configured to be operated by the controller. The smart water valve device also includes a battery configured to power the controller. The apparatus also includes an energy-generating device configured to charge the battery based on the water flow from the pressurized water source.

## Description

### USAGE AND TERMINOLOGY

In this disclosure, unless otherwise specified and/or unless the particular context clearly dictates otherwise, the terms "a" or "an" mean at least one, and the term "the" means the at least one.

### SUMMARY

In one aspect, an example apparatus is disclosed. The apparatus includes a smart water valve device. The smart water valve device includes a controller. The smart water valve device also includes a water valve configured to regulate water flow from a pressurized water source and configured to be operated by the controller. The smart water valve device also includes a battery configured to power the controller. The apparatus also includes an energy-generating device configured to charge the battery based on the water flow from the pressurized water source.

In another aspect, an example method is disclosed. The method is for use in connection with an apparatus including a smart water valve device and an energy-generating device. The smart water valve device includes (i) a controller, (ii) a water valve configured to regulate water flow from a pressurized water source and configured to be operated by the controller, and (iii) a battery configured to power the controller. The energy-generating device is configured to charge the battery based on the water flow from the pressurized water source. The method includes operating, by the controller, the water valve to regulate the water flow from the pressurized water source. The method also includes charging, by the energy-generating device, the battery based on the water flow from the pressurized water source.

In another aspect, an example non-transitory computer-readable medium is disclosed. The computer-readable medium includes instructions that, when executed by a processor, causes an apparatus to perform a set of operations. The apparatus comprises a smart water valve device and an energy-generating device. The smart water valve device includes (i) a controller, (ii) a water valve configured to regulate water flow from a pressurized water source and configured to be operated by the controller, and (iii) a battery configured to power the controller. The energy-generating device is configured to charge the battery based on the water flow from the pressurized water source. The operations include operating, by the controller, the water valve to regulate the water flow from the pressurized water source. The operations also include charging, by the energy-generating device, the battery based on the water flow from the pressurized water source.

### BRIEF DESCRIPTION OF THE DRAWINGS

Figure 1 is a diagram of an example system that includes a smart water valve device in which various described principles can be implemented.
Figure 2 is a diagram of another example system that includes a smart water valve device in which various described principles can be implemented.
Figure 3 is a diagram of a system that includes an upstream smart water valve device and a downstream smart water valve device.
Figure 4 is a simplified block diagram of an example computing system in which various described principles can be implemented.
Figure 5 depicts a water system that uses smart water valve devices.
Figure 6 depicts a water system that uses a smart water valve device.
Figure 7 is a flow chart of an example method.
Figure 8 is a flow chart of another example method.
Figure 9 is a flow chart of another example method.

### DETAILED DESCRIPTION

### I. Overview

A smart water valve device can be installed to regulate water flow through a pressurized water source, such as a pressurized water line or water pipe. For example, the smart water valve device can include a water valve that, when opened, enables downstream water flow through the pressurized water source. When the water valve is closed, the smart water valve device prevents downstream water flow through the pressurized water source. The smart water valve device can be responsive to a wireless command to open, or partially open, the water valve. To illustrate, the smart water valve device can monitor a wireless communication channel for a data packet that commands the smart water valve device to open the water valve. In response to receiving the data packet, the smart water valve device can generate a signal to open the water valve and enable downstream water flow through the pressurized water source.

Constantly monitoring the wireless communication channel for a data packet can increase the rate at which a battery, that powers the smart water valve device, discharges. Additionally, constantly opening and closing the water valve can increase the rate at which the battery discharges. As a result, the battery life of the battery can be relatively short, resulting in a need for frequent battery changes.

To increase the battery life of the battery, an energy-generating device is installed downstream of the water valve and within the pressurized water source. The energy-generating device can be included in the smart water valve device or can be a separate device that is electrically coupled to the smart water valve device. When the smart water valve device opens the water valve to enable downstream water flow through the pressurized water source, the downstream water flow applies a mechanical force to the energy-generating device, which in turn, causes the energy-generating device to generate electricity that charges the battery.

As a non-limiting example, the energy-generating device can include a turbine and a generator. When the smart water valve device opens the water valve to enable downstream water flow through the pressurized water source, the downstream water flow causes the turbine to move (e.g., spin or rotate). Based on the movement of the turbine, the generator generates electricity that is fed to the battery as a mechanism to charge the battery. It should be understood that the turbine is merely an example of the energy-generating device and is not intended to be limiting. As described below, other energy-generating devices can be used to charge the battery.

Thus, the techniques described herein extend the battery life of the battery that powers the smart water valve device by enabling the energy-generating device to charge the battery each time the water valve is at least partially opened. As a result, the battery has a longer life span, which in turn, reduces the frequency at which a user needs to replace the battery. Additionally, by implementing this "self-recharge" feature, the smart water valve device can be installed at locations that are not proximate to power outlets. For example, because the life of the battery can be prolonged through use of the smart water valve device (e.g., through opening the water valve), a power outlet and corresponding power line is not needed to provide power to the smart water valve device.

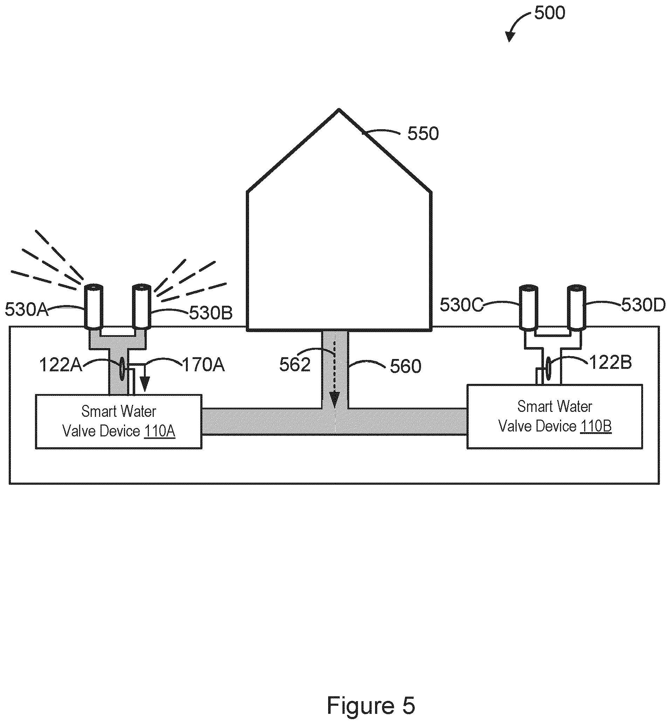

Below, particular embodiments are described herein with reference to the drawings. In the description, common features are designated by common reference numbers throughout the drawings. In some figures, multiple instances of a particular type of feature are used. Although these features are physically and/or logically distinct, the same reference number is used for each, and the different instances are distinguished by addition of a letter to the reference number. When the features as a group or a type are referred to herein (e.g., when no particular one of the features is being referenced), the reference number is used without a distinguishing letter. However, when one particular feature of multiple features of the same type is referred to herein, the reference number is used with the distinguishing letter. For example, referring to Figure 5, multiple smart water valve devices are illustrated and associated with reference numbers 110A and 110B. When referring to a particular one of these smart water valve devices, such as the smart water valve device 110A, the distinguishing letter "A" is used. However, when referring to any arbitrary one of these smart water valve devices or to these smart water valve devices as a group, the reference number 110 is used without a distinguishing letter.

### II. Example Smart Water Valve Devices

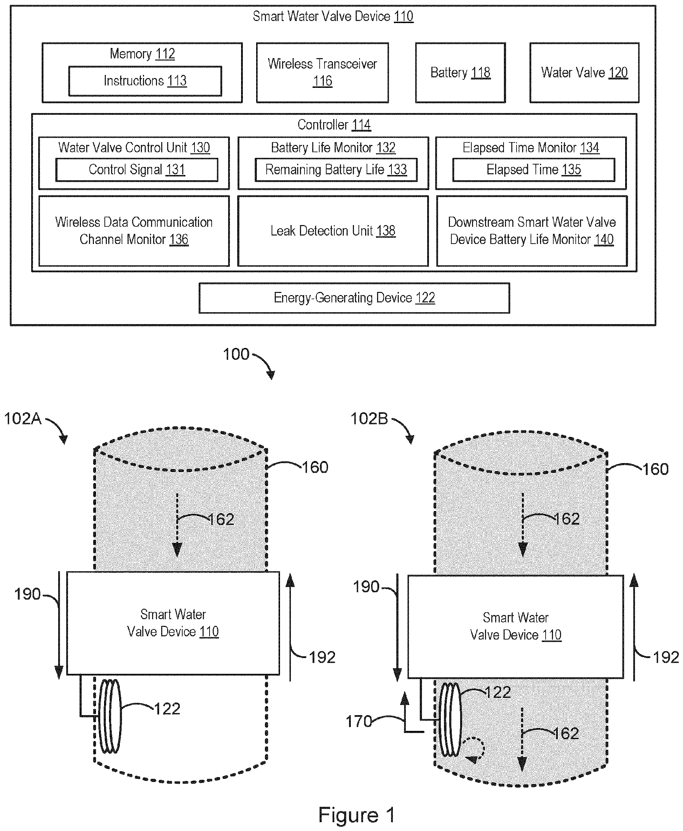

Figure 1 is a diagram of an example system 100 that includes a smart water valve device. For example, the system 100 includes a smart water valve device 110 that can regulate water flow by operating in a first state (e.g., a closed water valve state) or a second state (e.g., an at least partially opened water valve state). It should be understood that the second state also includes a completely opened water valve state. In a first example 102A illustrated in Figure 1, the smart water valve device 110 is operating in the first state whereby a water valve 120 of the smart water valve device 110 is closed. In a second example 102B illustrated in Figure 1, the smart water valve device 110 is operating in the second state whereby the water valve 120 is at least partially open (or completely open).

The smart water valve device includes a memory 112, a controller 114, a wireless transceiver 116, a battery 118, and the water valve 120. The memory 112 can correspond to a non-transitory computer-readable medium that stores instructions 113 executable by the controller 114 (e.g., a processor) to perform the operations described herein. In some implementations, the smart water valve device 110 includes an energy-generating device 122. In other implementations, the energy-generating device 122 is external to the smart water valve device 110. Thus, although the energy-generating device 122 is illustrated in Figure 1 as being included in the smart water valve device 110, in some implementations, the energy-generating device 122 can be external and electrically coupled to the smart water valve device 110.

The smart water valve device 110 can be configured to regulate water flow 162 from a pressurized water source 160. According to the examples 102, the pressurized water source 160 can corresponds to a water pipe, a water tank, a water line, or any other source that creates water pressure. It should be understood that the pressurized water source 160 is not limited to household water sources, such as water pipes. In some implementations, the pressurized water source 160 can correspond to external water sources, such as water towers, external water lines, etc.

To regulate the water flow 162, the water valve 120 of the smart water valve device 110 can switch between a closed state (as depicted in the first example 102A) and an open state (as depicted in the second example 102B). When the water valve 120 is in the closed state, as depicted in the first example 102A, the water flow 162 is blocked by the smart water valve device 110. However, when the water valve 120 is at least partially opened, as depicted in the second example 102B, the water flow 162 passes through the smart water valve device 110 (e.g., passes through the water valve 120) and continues to flow downstream 190. It should be understood that in the second example 102B, the water valve 120 can be partially opened or completely opened. If the water valve 120 is completely opened, the strength of the water flow 162, downstream 190 of the smart water valve device 110, is stronger than the strength of the water flow 162 when the water valve 120 is partially opened.

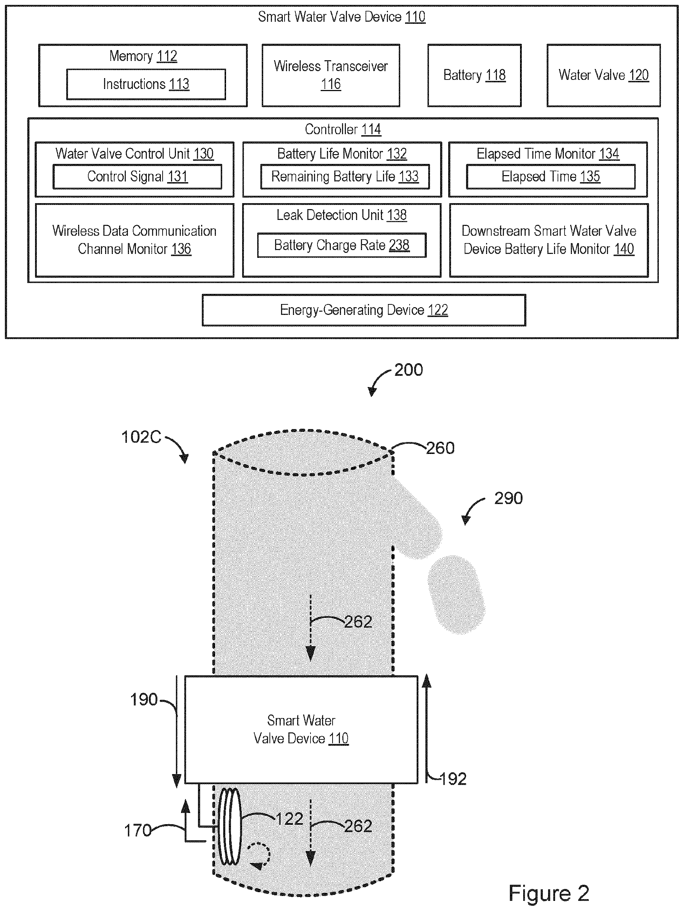

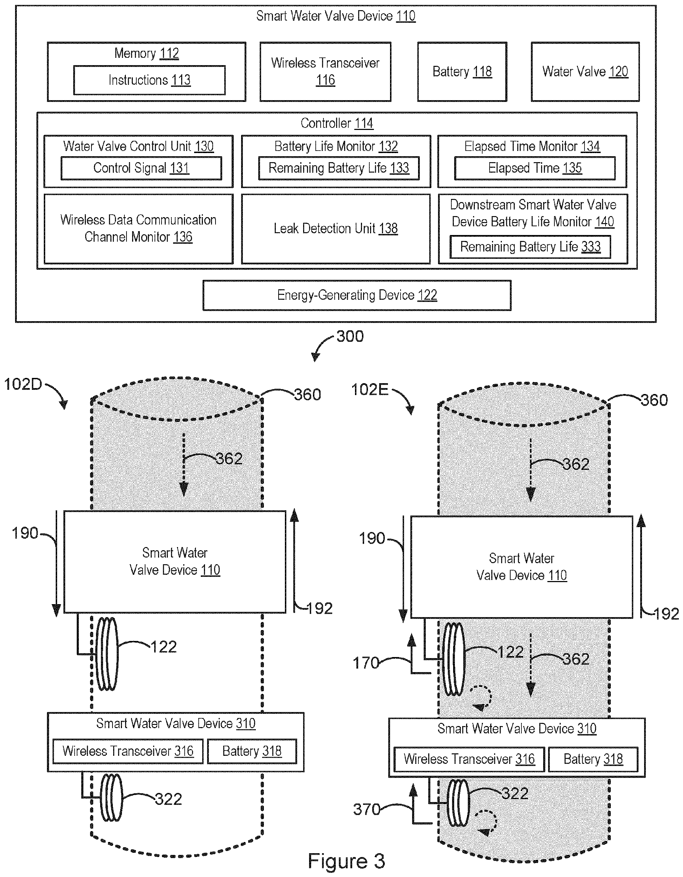

The controller 114 of the smart water valve device 110 includes a water valve control unit 130, a battery life monitor 132, an elapsed time monitor 134, a wireless data communication channel monitor 136, a leak detection unit 138, and a downstream smart water valve device battery life monitor 140. Operations associated with the leak detection unit 138 are described in greater detail with respect to Figure 2, and operations associated with the downstream smart water valve device battery life monitor 140 are described in greater detail with respect to Figure 3. In some implementations, one or more of the components 130, 132, 134, 136, 138, 140 of the controller 114 can be implemented using dedicated hardware. As a non-limiting example, one or more of the components 130, 132, 134, 136, 138, 140 of the controller 114 can be implemented using an application-specific integrated circuit (ASIC) or a field-programmable gate array (FPGA) device. In some implementations, one or more of the components 130, 132, 134, 136, 138, 140 of the controller 114 can be implemented using executable software. As a non-limiting example, the operations associated with one or more of the components 130, 132, 134, 136, 138, 140 of the controller 114 can be performed by executing the instructions 113 stored in the memory 112.

In some implementations, one or more of the components 130, 132, 134, 136, 138, 140 of the controller 114 are optional. As a non-limiting example, in some implementations, the controller 114 may not include the downstream smart water valve device battery life monitor 140. As another non-limiting example, in some implementations, the controller 114 may include the battery life monitor 132 and may not include the elapsed time monitor 134. However, in other implementations, the controller 114 may include the elapsed time monitor 134 and may not include the battery life monitor 132.

The water valve control unit 130 can be configured to generate a control signal 131 to at least partially open the water valve 120. For example, if the water valve 120 is closed (as depicted in the first example 102A), to at least partially open the water valve 120 to enable the water flow 162 to travel downstream 190 of the smart water valve device 110 (as depicted in the second example 102B), the water valve control unit 130 can generate the control signal 131 and send the control signal 131 signal to the water valve 120.

While it may be beneficial to partially open the water valve 120 to regulate the water flow 162, to conserve energy and preserve the life of the battery 118, in some implementations, the water valve 120 can either be completely closed or completely opened. For example, partially opening the water valve 120 may subject the smart water valve device 110 to utilizing processing components and resources to prevent the water valve 120 from completely closing or completely opening. As a result of utilizing these processing components and resources, in some scenarios, partially opening the water valve 120 may use energy that could otherwise be preserved if the water valve 120 was completely open. However, to completely open the water valve 120, the controller 114 has to "at least partially open" the water valve 120 by default. Thus, when the phrase "at least partially open" the water valve 120 is used herein, it also includes scenarios wherein the water valve 120 is completely open.

In some scenarios, the water valve control unit 130 can generate the control signal 131 to at least partially open the water valve 120 in response to a wireless instruction. To illustrate, the wireless transceiver 116 can be configured to wirelessly receive data packets via a wireless network. As a non-limiting example, the wireless transceiver 116 can be an Institute of Electrical and Electronics Engineers (IEEE) 802.11 ("Wifi") transceiver that receives Wifi data packets over a Wifi network. Although the smart water valve device 110 is illustrated as including the wireless transceiver 116, in some implementations, a separate wireless receiver and/or a separate wireless transmitter can be integrated into the smart water valve device 110. The wireless data communication channel monitor 136 can be configured to monitor a wireless data communication channel (associated with the wireless transceiver 116) for at least one data packet that includes a command to at least partially open the water valve 120. For example, a user may wirelessly send a command to the smart water valve device 110 to open the water valve 120. The wireless data communication channel monitor 136 can monitor the wireless data communication channel to determine whether the wireless transceiver 116 received the command (e.g., the data packet). In response to detecting the command (e.g., the data packet), the water valve control unit 130 can generate the control signal 131 to at least partially open the water valve 120.

However, the wireless data communication channel monitor 136 can consume power by continuously monitoring the wireless data communication channel for data packets. Furthermore, additional power can be consumed at the smart water valve device 110 by opening and closing the water valve 120. Thus, if the smart water valve device 110 is powered by the battery 118, the battery 118 may discharge at a relatively fast rate due to the above-described power consuming operations at the smart water valve device 110. To increase or extend the battery life of the battery 118, the techniques described herein utilize the energy-generating device 122 to charge the battery 118 based on the water flow 162.

To illustrate, as described above, in response to at least partially opening the water valve 120, the water flow 162 from the pressurized water source 160 continues to flow downstream 190 of the water valve 120. As illustrated in Figure 1, the energy-generating device 122 is downstream 190 of the water valve 120 and is located within the pressurized water source 160 such that the water flow 162 applies a mechanical force to the energy-generating device 122. The mechanical force applied by the water flow 162 can cause the energy-generating device 122 to generate electricity 170 that charges the battery 118. As a non-limiting example, in one implementation, the energy-generating device 122 can include a turbine downstream 190 of the water valve 120. When the water valve 120 is at least partially open, as illustrated in the second example 102B, the water flow 162 from the pressurized water source 160 causes movement at the turbine (e.g., cause the turbine to spin or rotate). Based on the movement at the turbine, a generator associated with the energy-generating device 122 can generate electricity 170 that charges the battery 118.

As another non-limiting example, in one implementation, the energy-generating device 122 can include a piezoelectric material (e.g., piezoelectric crystal) downstream 190 of the water valve 120. When the water valve 120 is at least partially open, as illustrated in the second example 102B, the water flow 162 from the pressurized water source 160 applies mechanical pressure to the piezoelectric material. Based on the mechanical pressure applied to the piezoelectric material, the piezoelectric material generates electricity 170 that charges the battery 118.

It should be understood that that above implementations are merely illustrative examples of the energy-generating device 122 and should not be construed as limiting. In other implementations, the energy-generating device 122 can include other devices. As a non-limiting example, in another implementation, the energy-generating device 122 can include a piston paired with an electrical generator, a Pelton wheel paired with an electrical generator, a paddle wheel paired with an electrical generator, etc.

Thus, as described above, opening the water valve 120 to apply mechanical pressure to the energy-generating device 122 can be used to charge the battery 118. To ensure that the water valve 120 is opened at a frequency that facilitates adequate charging of the battery 118, the controller 114 can implement certain protocols.

According to one protocol, the controller 114 can at least partially open the water valve 120 based on a remaining battery life 133 associated with the battery 118. To illustrate, the battery life monitor 132 can be configured to monitor the remaining battery life 133 associated with the battery 118. In response to determining that the remaining battery life 133 fails to satisfy a threshold level, the battery life monitor 132 can send a signal to the water valve control unit 130 to alert the water valve control unit 130 that the remaining battery life 133 is low. As a non-limiting example, if the remaining battery life 133 falls below ten (10) percent, the battery life monitor 132 can send a signal to the water valve control unit 130 to alert the water valve control unit 130 that the remaining battery life 133 is low. Based on the signal, the water valve control unit 130 can generate the control signal 131 to at least partially open the water valve 120, and the mechanical pressure (from the water flow 162) applied to the energy-generating device 122 in response to opening the water valve 120 can cause the energy-generating device 122 to charge the battery 118.

According to another protocol, the controller 114 can at least partially open the water valve 120 based on an elapsed time 135 since the water valve 120 was last opened. To illustrate, the elapsed time monitor 134 can be configured to monitor the elapsed time 135 since the water valve 120 was at least partially open. In response to determining that the elapsed time 135 exceeds an elapsed time limit, the elapsed time monitor 134 can send a signal to the water valve control unit 130 to alert the water valve control unit 130 that the water valve 120 has not been opened recently. As a non-limiting example, software integrated into the smart water valve device 110 can indicate that the battery 118 is estimated to completely lose battery life after three months if the battery 118 is not charged. In this scenario, if the elapsed time monitor 134 determines that the elapsed time 135 since the water valve 120 was last opened exceeds seventy-five (75) days (e.g., approximately two-and-a-half (2.5) months), the elapsed time monitor 134 can send the signal to the water valve control unit 130 to alert the water valve control unit 130 that the water valve 120 has not been opened recently. Based on the signal, the water valve control unit 130 can generate the control signal 131 to at least partially open the water valve 120, and the mechanical pressure (from the water flow 162) applied to the energy-generating device 122 in response to opening the water valve 120 can cause the energy-generating device 122 to charge the battery 118.

According to another protocol, the controller 114 can periodically open (or partially open) the water valve 120 to enable the energy-generating device 122 to charge the battery 118. To illustrate, the water valve control unit 130 can periodically generate the control signal 131 to at least partially open the water valve 120. As non-limiting examples, the water valve control unit 130 can generate the control signal 131 daily, weekly, biweekly, monthly, bimonthly, etc.

The techniques described with respect to Figure 1 extend the life of the battery 118, and thus the life of the smart water valve device 110, by enabling the energy-generating device 122 to charge the battery 118 each time the water valve 120 is at least partially opened. For example, by opening the water valve 120, mechanical pressure associated with the water flow 162 is applied to the energy-generating device 122 and causes the energy-generating device 122 to generate electricity 170 that charges the battery 118. As a result, the battery 118 has a longer life span, which in turn, reduces the need for a user to replace the battery 118. Additionally, as described below, by implementing this "self-recharge" feature, the smart water valve device 110 can be installed at locations that are not proximate to power outlets. For example, because the life of the battery 118 can be prolonged through use of the smart water valve device 110 (e.g., through opening the water valve 120), a power outlet and corresponding power line is not needed to provide power to the smart water valve device 110.

As described with respect to Figures 2 and 3, the smart water valve device 110 can also be used to detect leaks upstream 192 from the water valve 120 and to provide water flow 162 to downstream smart water valve devices in response to an indication that the downstream smart water valve devices have low battery power. For example, as described with respect to Figure 2, the leak detection unit 138 can determine whether a leak is present upstream 192 from the water valve 120. Additionally, as described with respect to Figure 3, the downstream smart water valve device battery life monitor 140 can determine whether to open the water valve 120 to provide water flow 162 to a downstream smart water valve device.

Figure 2 is a diagram of another example system 200 that includes a smart water valve device. For example, the system 200 includes the smart water valve device 110 of Figure 1. In a third example 102C illustrated in Figure 2, the smart water valve device 110 is operating in the second state whereby the water valve 120 is at least partially open (or completely open).

The smart water valve device 110 can be configured to regulate water flow 262 from a pressurized water source 260. Similar to the pressurized water source 160, the pressurized water source 260 can correspond to a water pipe, a water tank, a water line, or any other source that creates water pressure. According to the third example 102C, the pressurized water source 260 includes a leak 290 located upstream 192 of the smart water valve device 110.

In Figure 2, the water valve 120 is at least partially open and water flow 262 from the pressurized water source 260 passes through the smart water valve device 110 (e.g., passes through the water valve 120) and continues to flow downstream 190. As a result, the water flow 262 applies a mechanical force to the energy-generating device 122, downstream 190 of the water valve 120, and causes the energy-generating device 122 to generate electricity 170 that charges the battery 118, in a similar manner as described with respect to Figure 1. However, because of the leak 290, the strength of the water flow 262, and thus the magnitude of the mechanical force applied to the energy-generating device 122, is reduced. As a result, the energy-generating device 122 moves at a slower rate, and thus charges the battery 118 at a slower rate.

Because of reduced charging rate based on the leak 290, the controller 114 can be configured to detect whether a leak 290 is present based on the rate at which the battery 118 charges. For example, the leak detection unit 138 can be configured to determine a battery charge rate 238 when the water valve 120 is at least partially open. If the battery charge rate 238 fails to satisfy a threshold (e.g., is below a threshold charge rate), the leak detection unit 138 can determine that a leak 290 is present upstream 192 of the water valve 120. As a non-limiting example, if there is no leak present upstream of the water valve 120, when the water valve 120 is completely open, the typical charge rate for the battery 118 can be four (4) amperes per hour. Assuming that the threshold for determining that a leak 290 is present is seventy-five percent (75%) of the typical charge rate, if the leak detection unit 138 determines that the battery charge rate 238 is less than three (3) amperes per hour when the water valve 120 is completely open, the leak detection unit 138 can determine that there is a leak 290 upstream 192 of the water valve 120.

It should be understood that the typical charge rate and the charge rate threshold described above are merely for illustrative purposes and should not be construed as limiting. In other implementations, the typical charge rate and the charge rate threshold may vary.

Thus, the techniques described with respect to Figure 2 enable the smart water valve device 110 to detect leaks 290 in the pressurized water source 260 based on the battery charge rate 238 when the water valve 120 is at least partially open. Upon detection of a leak 290, the smart water valve device 110 can generate and send a message (via the wireless transceiver 116) to a user to indicate the presence of the leak 290.

Figure 3 is a diagram of another example system 300 that includes a smart water valve device. For example, the system 300 includes the smart water valve device 110 of Figure 1 and another smart water valve device 310 downstream 190 of the smart water valve device 110. In a fourth example 102D illustrated in Figure 3, the smart water valve device 110 is operating in the first state whereby the water valve 120 of the smart water valve device 110 is closed. In a fifth example 102E illustrated in Figure 3, the smart water valve device 110 is operating in the second state whereby the water valve 120 is at least partially open (or completely open).

The smart water valve device 310 can have a similar configuration to the smart water valve device 110 and can operate in substantially similar manner. For example, the smart water valve device 310 can include a memory (not shown), a wireless transceiver 316, a battery 318, a water valve (not shown), a controller (not shown), and an energy-generating device 322. In a similar manner as described with respect to the smart water valve device 110, the energy-generating device 322 associated with the smart water valve device 310 can charge the battery 318 of the smart water valve device 310 based on water flow 362. However, because the smart water valve device 310 is downstream 190 from the smart water valve device 110, water flow 362 from a pressurized water source 360 cannot reach the smart water valve device 310 unless the water valve 120 of the smart water valve device 110 is at least partially open. Thus, to ensure that the water flow 362 is available to the smart water valve device 310 for battery 318 recharging operations, the smart water valve device 110 has to at least partially open the water valve 120.

To determine whether there is a need to open the water valve 120 to enable the water flow 362 to reach the smart water valve device 310 for battery 318 recharging operations, the smart water valve device 110 can monitor a remaining battery life 333 associated with the battery 318 of the smart water valve device 310. To illustrate, in a similar manner as the battery life monitor 132 of the smart water valve device 110, the smart water valve device 310 can include a battery life monitor (not shown) that monitors a remaining battery life 333 of the battery 318. Using the wireless transceiver 316, the smart water valve device 310 can send an indication of the remaining battery life 333 to the smart water valve device 110 over a wireless network. The wireless transceiver 116 of the smart water valve device 110 can receive the indication from the smart water valve device 310, and the downstream smart water valve device battery life monitor 140 can monitor the remaining battery life 333 associated with the battery 318 based on the indication.

In response to a determination that the remaining battery life 333 associated with the battery 318 fails to satisfy a threshold level, the downstream smart water valve device battery life monitor 140 can send a signal to the water valve control unit 130 to alert the water valve control unit 130 that the remaining battery life 333 is low. As a non-limiting example, if the remaining battery life 333 falls below ten (10) percent, the downstream smart water valve device battery life monitor 140 can send a signal to the water valve control unit 130 to alert the water valve control unit 130 that the remaining battery life 333 is low. Based on the signal, the water valve control unit 130 can generate the control signal 131 to at least partially open the water valve 120, and the water flow 362 can travel downstream 190 to the smart water valve device 310, as depicted in the fifth example 102E.

Once the water flow 362 travels downstream 190 to the smart water valve device 310, the smart water valve device 310 can at least partially open an internal water valve to enable the water flow 362 to apply a mechanical force to the energy-generating device 322. The mechanical force applied by the water flow 362 can cause the energy-generating device 322 to generate electricity 370 that charges the battery 318.

Thus, the techniques described with respect to Figure 3 enable the smart water valve device 110 to monitor the remaining battery life 333 associated with the battery 318 of the smart water valve device 310. Based on the remaining battery life 333, the smart water valve device 110 can at least partially open the water valve 120 to ensure that the water flow 362 is available to the smart water valve device 310 for battery 318 recharging operations.

### III. Example Computing System

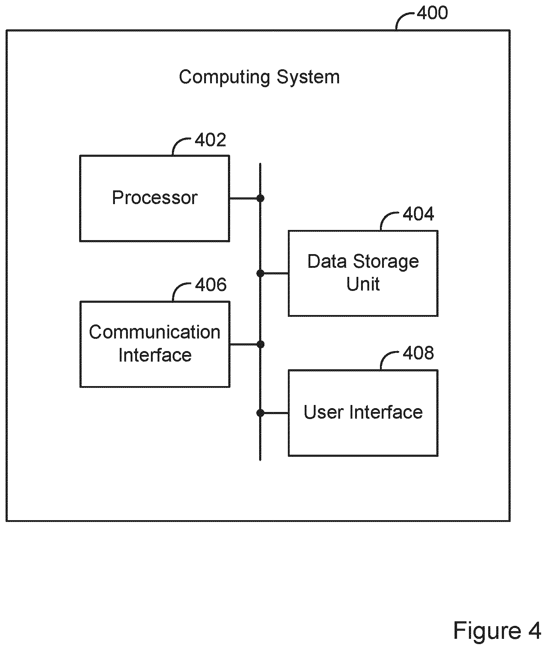

Figure 4 is a simplified block diagram of an example computing system 400. The computing system 400 can be configured to perform and/or can perform various operations, such as the operations described in this disclosure. The computing system 400 can include various components, such as a processor 402, a data storage unit 404, a communication interface 406, and/or a user interface 408.

The processor 402 can be or include a general-purpose processor (e.g., a microprocessor) and/or a special-purpose processor (e.g., a digital signal processor). The processor 402 can execute program instructions included in the data storage unit 404 as described below.

The data storage unit 404 can be or include one or more volatile, nonvolatile, removable, and/or non-removable storage components, such as magnetic, optical, and/or flash storage, and/or can be integrated in whole or in part with the processor 402. Further, the data storage unit 404 can be or include a non-transitory computer-readable storage medium, having stored thereon program instructions (e.g., compiled or non-compiled program logic and/or machine code) that, upon execution by the processor 402, cause the computing system 400 and/or another computing system to perform one or more operations, such as the operations described in this disclosure. These program instructions can define, and/or be part of, a discrete software application.

In some instances, the computing system 400 can execute program instructions in response to receiving an input, such as an input received via the communication interface 406 and/or the user interface 408. The data storage unit 404 can also store other data, such as any of the data described in this disclosure.

The communication interface 406 can allow the computing system 400 to connect with and/or communicate with another entity according to one or more protocols. Therefore, the computing system 400 can transmit data to, and/or receive data from, one or more other entities according to one or more protocols. In one example, the communication interface 406 can be or include a wired interface, such as an Ethernet interface or a High-Definition Multimedia Interface (HDMI). In another example, the communication interface 406 can be or include a wireless interface, such as a cellular or WI-FI interface.

The user interface 408 can allow for interaction between the computing system 400 and a user of the computing system 400. As such, the user interface 408 can be or include an input component such as a keyboard, a mouse, a remote controller, a microphone, and/or a touch-sensitive panel. The user interface 408 can also be or include an output component such as a display screen (which, for example, can be combined with a touch-sensitive panel) and/or a sound speaker.

The computing system 400 can also include one or more wired and/or wireless connection mechanisms that connect various components within the computing system 400. For example, the computing system 400 can include the connection mechanisms represented by lines that connect components of the computing system 400, as shown in Figure 4.

The computing system 400 can include one or more of the above-described components and can be configured or arranged in various ways. For example, the computing system 400 can be configured as a server and/or a client (or perhaps a cluster of servers and/or a cluster of clients) operating in one or more server-client type arrangements, such as a partially or fully cloud-based arrangement, for instance.

The smart water valve device 110 can take the form of a computing system, such as the computing system 400. In some cases, some or all of these entities can take the form of a more specific type of computing system.

### IV. Example Water Systems Using Smart Water Valve Devices

Figure 5 depicts a water system 500 that uses smart water valve devices. For example, in Figure 5, the water system 500 includes a pressurized water source 560 that is coupled to a building 550 and to a pair of smart water valve devices 11 0A, 11 0B. The pressurized water source 560 can correspond to an external or underground water line that routes water flow 562 to different sprinklers 530 via the smart water valve devices 110. For example, the pressurized water source 560 can route the water flow 562 from the building 550 to the sprinklers 530A, 530B via the smart water valve device 110A, and the pressurized water source 560 can route the water flow 562 from the building 550 to the sprinklers 530C, 530D via the smart water valve device 110B.

In Figure 5, the sprinklers 530A, 530B are activated and the sprinklers 530C, 530D are deactivated. To activate the sprinklers 530A, 530B, the smart water valve device 110A at least partially opens an internal water valve to enable the water flow 562 to flow downstream from the building 550 to the sprinklers 530A, 530B. In some scenarios, the sprinklers 530A, 530B are activated in response to the smart water valve device 110A wirelessly receiving a data packet that includes a command to at least partially open the internal water valve. In other scenarios, the sprinklers 530A, 530B are activated in response to the smart water valve device 110A periodically opening the internal water valve, opening the internal water valve in response to a low battery life determination, opening the internal water valve in response to an elapsed time exceeding an elapsed time threshold, etc.

When the sprinklers 530A, 530B are activated, the water flow 562 applies a mechanical force to the energy-generating device 122A downstream of the internal water valve of the smart water valve device 110A. The mechanical force applied by the water flow 562 can cause the energy-generating device 122A to generate electricity 170A that charges a battery of the smart water valve device 110A.

Because the internal water valve of the smart water valve device 110B is closed, the water flow 562 cannot flow downstream of the water valve to apply a mechanical force to the energy-generating device 122B. Thus, in order to charge a battery of the smart water valve device 110B, the smart water valve device 110B can at least partially open an internal water valve to enable the water flow 562 to apply a mechanical force to the energy-generating device 122B.

The techniques described with respect to Figure 5 enable the smart water valve devices 110A, 110B to be installed without running power lines through the ground. For example, because the battery life of the smart water valve devices 110A, 110B can be extended each time internal water valves of the smart water valve devices 11 0A, 11 0B are opened to activate associated sprinklers 530, a power outlet and corresponding power line is not needed to provide power to the smart water valve devices 110A, 110B. As a result, greater installation flexibility can be achieved.

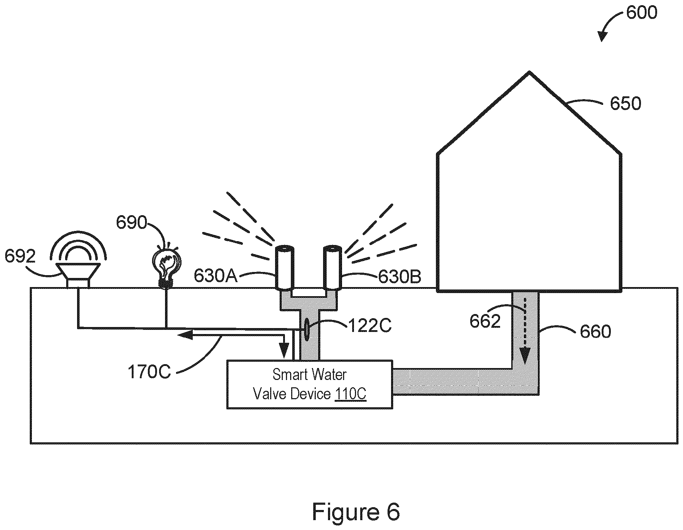

Figure 6 depicts a water system 600 that uses a smart water valve device. For example, in Figure 6, the water system 600 includes a pressurized water source 660 that is coupled to a building 650 and to a smart water valve devices 110C. The pressurized water source 660 can correspond to an external or underground water line that routes water flow 662 to sprinklers 630A, 630B via the smart water valve device 110C.

In Figure 6, the sprinklers 630A, 630B are activated. To activate the sprinklers 630A, 630B, the smart water valve device 110C at least partially opens an internal water valve to enable the water flow 662 to flow downstream from the building 650 to the sprinklers 630A, 630B. In some scenarios, the sprinklers 630A, 630B are activated in response to the smart water valve device 110C wirelessly receiving a data packet that includes a command to at least partially open the internal water valve.

When the sprinklers 630A, 630B are activated, the water flow 662 applies a mechanical force to the energy-generating device 122C downstream of the internal water valve of the smart water valve device 110C. The mechanical force applied by the water flow 662 can cause the energy-generating device 122C to generate electricity 170C that charges a battery of the smart water valve device 110C.

Additionally, the electricity 170C can be routed to power emergency lights 690 and/or to power an alarm system 692. For example, in one implementation, when the water flow 662 from the pressurized water source 660 applies the mechanical force to the energy-generating device 122C, the electricity 170C generated by the energy-generating device 122C can power the emergency lights 690. As another example, in one implementation, when the water flow 662 from the pressurized water source 660 applies the mechanical force to the energy-generating device 122C, the electricity 170C generated by the energy-generating device 122C can power the alarm system 692.

### V. Example Methods

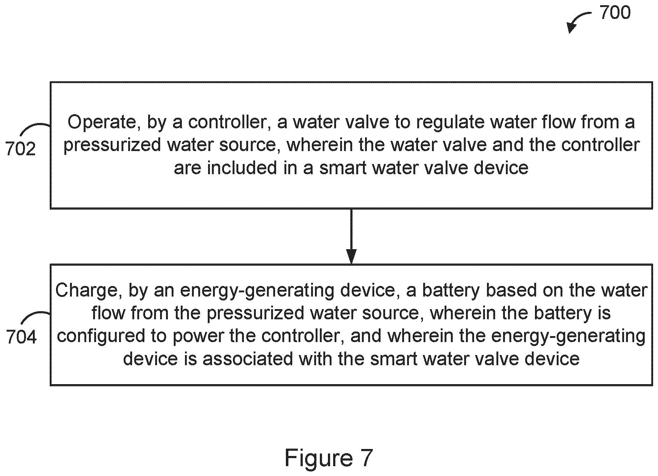

Figure 7 is a flow chart illustrating an example method 700. The method 700 can be carried out by a smart water valve device, such as the smart water valve device 110.

The method 700 includes operating, by a controller, a water valve to regulate water flow from a pressurized water source, at block 702. The water valve and the controller are included in a smart water valve device. For example, referring to Figure 1, the controller 114 can operate the water valve 120 to regulate the water flow 162 from the pressurized water source 160. The water valve 120 and the controller 114 are included in the smart water valve device 110.

The method 700 also includes charging, by an energy-generating device, a battery based on the water flow from the pressurized water source, at block 704. The battery is configured to power the controller, and the energy-generating device is associated with the smart water valve device. For example, referring to Figure 1, the energy-generating device 122 can charge the battery 118 based on the water flow 162 from the pressurized water source 160. The battery 118 is configured to power the controller 114, and the energy-generating device 122 is associated with the smart water valve device 110.

In one implementation of the method 700, the energy-generating device 122 is included in the smart water valve device 110 and is downstream 190 of the water valve 120. In another implementation of the method 700, the energy-generating device 122 is external to the smart water valve device 110 and is downstream 190 of the water valve 120. The energy-generating device 122 can be within the pressurized water source 160 such that mechanical force from the water flow 162 can be applied to the energy-generating device 122.

According to one implementation of the method 700, the energy-generating device 122 includes a turbine downstream 190 of the water valve 120. When the water valve 120 is at least partially open, the water flow 162 from the pressurized water source 160 causes movement at the turbine. The energy-generating device can also include a generator configured to generate electricity 170 that charges the battery 118 based on the movement at the turbine.

According to one implementation of the method 700, the energy-generating device 122 includes a piezoelectric material downstream 190 of the water valve 120. When the water valve 120 is at least partially open, the water flow 162 from the pressurized water source 160 apples mechanical pressure to the piezoelectric material, and the piezoelectric material is configured to generate electricity 170 that charges the battery 118 based on the mechanical pressure.

According to one implementation, the method 700 includes generating, by the controller 114, a control signal 131 to at least partially open the water valve 120. In one embodiment, the method 700 includes monitoring, by the controller 114, a wireless data communication channel for at least one data packet that includes a command to at least partially open the water valve 120. The control signal 131 can be generated in response to detecting at least one data packet. In another embodiment, the method 700 includes monitoring, by the controller 114, a remaining battery life 133 associated with the battery 118. The control signal can be generated in response to the remaining battery life 133 failing to satisfy a threshold level. In another embodiment, the method 700 includes monitoring, by the controller 114, an elapsed time 135 since the water valve 120 was at least partially opened. The control signal can be generated in response to the elapsed time 135 exceeding an elapsed time limit. In yet another embodiment, the control signal 131 can be generated periodically.

According to one implementation, the method 700 includes determining whether a leak 290 is present upstream 192 of the water valve 120 based on a rate at which the battery 118 charges (e.g., based on the battery charge rate 238) when the water valve 120 is at least partially open.

According to one implementation, the method 700 includes powering, by the energy-generating device 122, emergency lights 690 based on the water flow 662 from the pressurized water source 660. According to one implementation, the method 700 includes powering, by the energy-generating device 122, an alarm system 692 based on the water flow 662 from the pressurized water source 660.

According to one implementation, the method 700 includes monitoring, by the controller 114, a remaining battery life 333 associated with a second battery 318 associated with a second smart water valve device 310 that is downstream 190 of the smart water valve device 110. The method 700 also includes generating a control signal 131 to at least partially open the water valve 120 in response to a determination that the remaining battery life 333 associated with the second battery 118 fails to satisfy a threshold level. The water flow 362 from the pressurized water source 360 travels downstream 190 to the second smart water valve device 310 in response to at least partially opening the water valve 120.

The method 700 of Figure 7 extends the life of the battery 118, and thus the life of the smart water valve device 110, by enabling the energy-generating device 122 to charge the battery 118 each time the water valve 120 is at least partially opened. For example, by opening the water valve 120, mechanical pressure associated with the water flow 162 is applied to the energy-generating device 122 and causes the energy-generating device 122 to generate electricity 170 that charges the battery 118. As a result, the battery 118 has a longer life span, which in turn, reduces the need for a user to replace the battery 118. Additionally, as described below, by implementing this "self-recharge" feature, the smart water valve device 110 can be installed at locations that are not proximate to power outlets. For example, because the life of the battery 118 can be prolonged through use of the smart water valve device 110 (e.g., through opening the water valve 120), a power outlet and corresponding power line is not needed to provide power to the smart water valve device 110.

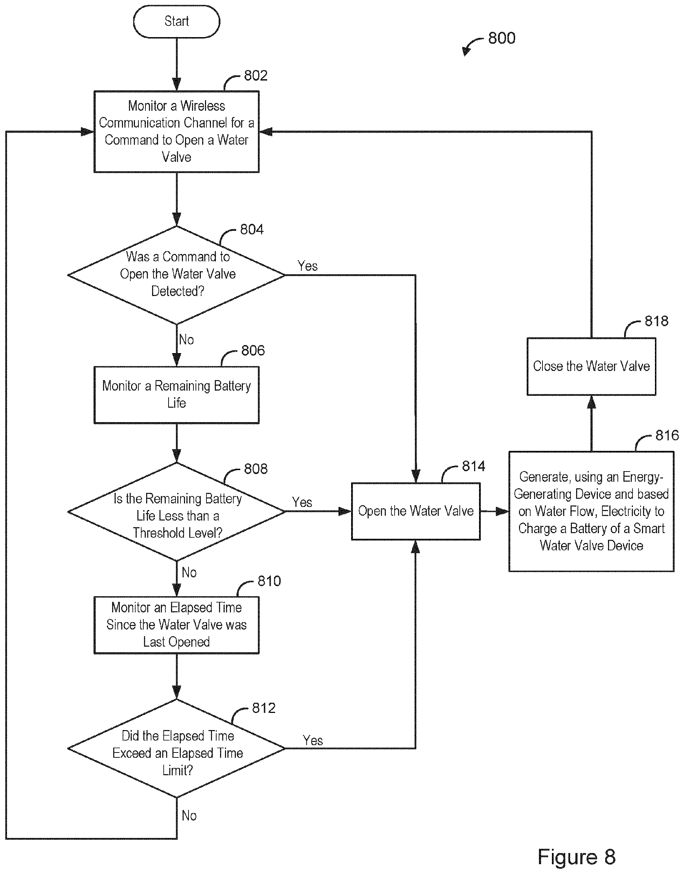

Figure 8 is a flow chart illustrating another example method 800. The method 800 can be carried out by a smart water valve device, such as the smart water valve device 110.

According to the method 800, at block 802, a smart water valve device monitors a wireless communication channel for a command to open a water valve. For example, referring to Figure 1, the wireless data communication channel monitor 136 monitors the wireless communication channel (associated with the wireless transceiver 116) for a command to open the water valve 120.

At decision block 804, the smart water valve device determines whether a command to open the water valve was detected. For example, referring to Figure 1, the wireless data communication channel monitor 136 determines whether a command to open the water valve 120 was detected (e.g., received) by the wireless transceiver 116. If a command to open the water valve was detected, at decision block 804, the method 800 moves to block 814. If a command to open the water valve was not detected, at decision block 804, the method 800 moves to block 806.

At block 806, the smart water valve device monitors a remaining battery life of a battery associated with the smart water valve device. For example, referring to Figure 1, the battery life monitor 132 monitors the remaining battery life 133 of the battery 118 that powers the controller 114 (e.g., that powers the smart water valve device 110).

At decision block 808, the smart water valve device determines whether the remaining battery life of the battery is less than a threshold level. For example, referring to Figure 1, the battery life monitor 132 determines whether the remaining battery life 133 of the battery 118 is less than a threshold level. If the remaining battery life of the battery is less than the threshold level, at decision block 808, the method 800 moves to block 814. If the remaining battery life of the battery is not less than the threshold level, at decision block 808, the method 800 moves to block 810.

At block 810, the smart water valve device monitors an elapsed time since the water valve was last opened. For example, referring to Figure 1, the elapsed time monitor 134 monitors the elapsed time 135 since the water valve 120 was last opened.

At decision block 812, the smart water valve device determines whether the elapsed time exceeded an elapsed time limit. For example, referring to Figure 1, the elapsed time monitor 134 determines whether the elapsed time 135 exceeded an elapsed time limit. If the elapsed time exceeded the elapsed time limit, at decision block 812, the method 800 moves to block 814. If the elapsed time did not exceed the elapsed time limit, the method 800 moves back to block 802.

At block 814, the smart water valve device opens the water valve. For example, referring to Figure 1, the water valve control unit 130 generates the control signal 131 to at least partially open the water valve 120.

At block 816, the energy-generating device generates, based on water flow, electricity to charge a battery of the smart water valve device. For example, referring to Figure 1, the water flow 162 applies a mechanical force to the energy-generating device 122 in response to the water valve 120 opening. Based on the mechanical force, the energy-generating device 122 generates electricity 170 to charge the battery 118.

At block 818, the smart water valve device closes the water valve and the method 800 returns to block 802. For example, referring to Figure 1, the water valve control unit 130 generates a signal to close the water valve 120.

The method 800 of Figure 8 extends the life of the battery 118, and thus the life of the smart water valve device 110, by enabling the energy-generating device 122 to charge the battery 118 each time the water valve 120 is at least partially opened. For example, by opening the water valve 120, mechanical pressure associated with the water flow 162 is applied to the energy-generating device 122 and causes the energy-generating device 122 to generate electricity 170 that charges the battery 118. As a result, the battery 118 has a longer life span, which in turn, reduces the need for a user to replace the battery 118. Additionally, as described below, by implementing this "self-recharge" feature, the smart water valve device 110 can be installed at locations that are not proximate to power outlets. For example, because the life of the battery 118 can be prolonged through use of the smart water valve device 110 (e.g., through opening the water valve 120), a power outlet and corresponding power line is not needed to provide power to the smart water valve device 110.

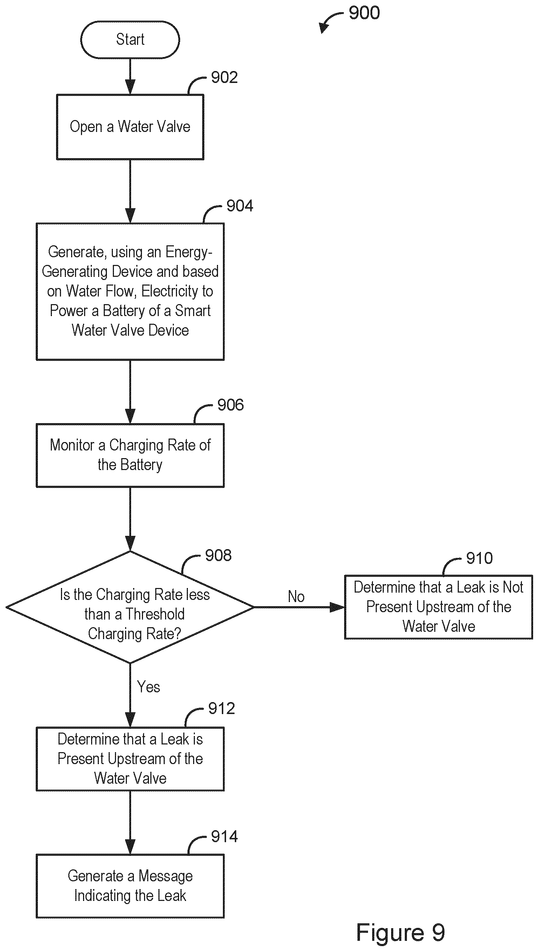

Figure 9 is a flow chart illustrating another example method 900. The method 900 can be carried out by a smart water valve device, such as the smart water valve device 110.

At block 902, the smart water valve device opens the water valve. For example, referring to Figure 1, the water valve control unit 130 generates the control signal 131 to at least partially open the water valve 120.

At block 904, the energy-generating device generates, based on water flow, electricity to charge a battery of the smart water valve device. For example, referring to Figure 1, the water flow 162 applies a mechanical force to the energy-generating device 122 in response to the water valve 120 opening. Based on the mechanical force, the energy-generating device 122 generates electricity 170 to charge the battery 118.

At block 906, the smart water valve device monitors a charging rate of the battery. For example, referring to Figure 2, the leak detection unit 138 monitors the battery charge rate 238 of the battery 118 while the water valve 120 is at least partially open.

At decision block 908, the smart water valve device determines whether the charging rate is less than a threshold charging rate. For example, referring to Figure 2, the leak detection unit 138 determines whether the battery charge rate 238 is less than a threshold charging rate. If the charging rate is not less than the threshold charging rate, at decision block 908, the method 900 moves to block 910. At block 910, the smart water valve device determines that a leak is not present upstream of the water valve.

If the charging rate is less than the threshold charging rate, at decision block 908, the method 900 moves to block 912. At block 912, the smart water valve device determines that a leak is present upstream of the water valve. For example, referring to Figure 2, the leak detection unit 138 determines that the leak 290 is present upstream 192 of the water valve 120. At block 914, the smart water valve device generates a message indicating the leak. For example, referring to Figure 2, upon detection of the leak 290, the smart water valve device 110 generates and sends a message (via the wireless transceiver 116) to a user to indicate the presence of the leak 290.

Thus, the method 900 of Figure 9 enable the smart water valve device 110 to detect leaks 290 in the pressurized water source 260 based on the battery charge rate 238 when the water valve 120 is at least partially open.

### VI. Example Variations

Although some of the acts and/or functions described in this disclosure have been described as being performed by a particular entity, the acts and/or functions can be performed by any entity, such as those entities described in this disclosure. Further, although the acts and/or functions have been recited in a particular order, the acts and/or functions need not be performed in the order recited. However, in some instances, it can be desired to perform the acts and/or functions in the order recited. Further, each of the acts and/or functions can be performed responsive to one or more of the other acts and/or functions. Also, not all of the acts and/or functions need to be performed to achieve one or more of the benefits provided by this disclosure, and therefore not all of the acts and/or functions are required.

Although certain variations have been discussed in connection with one or more examples of this disclosure, these variations can also be applied to all of the other examples of this disclosure as well.

Although select examples of this disclosure have been described, alterations and permutations of these examples will be apparent to those of ordinary skill in the art. Other changes, substitutions, and/or alterations are also possible without departing from the invention in its broader aspects as set forth in the following claims.

## Claims

1. An apparatus comprising:
a smart water valve device comprising:
a controller;
a water valve configured to regulate water flow from a pressurized water source and configured to be operated by the controller; and
a battery configured to power the controller; and
an energy-generating device configured to charge the battery based on the water flow from the pressurized water source.

2. The apparatus of claim 1, wherein the energy-generating device is downstream of the water valve.

3. The apparatus of claim 1, wherein the smart water valve device further comprises the energy-generating device.

4. The apparatus of claim 1, wherein the energy-generating device is external to the smart water valve device.

5. The apparatus of claim 1, wherein the energy-generating device comprises:
a turbine downstream of the water valve, wherein, when the water valve is at least partially open, the water flow from the pressurized water source causes movement at the turbine; and
a generator configured to generate electricity that charges the battery based on the movement at the turbine.

6. The apparatus of claim 1, wherein the energy-generating device comprises a piezoelectric material downstream of the water valve, wherein, when the water valve is at least partially open, the water flow from the pressurized water source applies mechanical pressure to the piezoelectric material, and wherein the piezoelectric material is configured to generate electricity that charges the battery based on the mechanical pressure.

7. The apparatus of claim 1, wherein the controller is configured to generate a control signal to at least partially open the water valve, and wherein the energy-generating device charges the battery based on the water flow in response to at least partially opening the water valve.

8. The apparatus of claim 7, wherein the controller is further configured to monitor a wireless data communication channel for at least one data packet that includes a command to at least partially open the water valve, and wherein the control signal is generated in response to detecting the at least one data packet.

9. The apparatus of claim 7, wherein the controller is further configured to monitor a remaining battery life associated with the battery, and wherein the control signal is generated in response to the remaining battery life failing to satisfy a threshold level.

10. The apparatus of claim 7, wherein the controller is further configured to monitor an elapsed time since the water valve was at least partially opened, and wherein the control signal is generated in response to the elapsed time exceeding an elapsed time limit.

11. The apparatus of claim 7, wherein the controller is further configured to determine whether a leak is present upstream of the water valve based on a rate at which the battery charges when the water valve is at least partially open.

12. The apparatus of claim 1, wherein the energy-generating device is further configured to:
power emergency lights based on the water flow from the pressurized water source; or
power an alarm system based on the water flow from the pressurized water source.

13. The apparatus of claim 1, wherein the controller is further configured to:
monitor a remaining battery life associated with a second battery associated with a second smart water valve device that is downstream of the smart water valve device; and
generate a control signal to at least partially open the water valve in response to a determination that the remaining battery life associated with the second battery fails to satisfy a threshold level, wherein the water flow from the pressurized water source travels downstream to the second smart water valve device in response to at least partially opening the water valve.

14. A method for use in connection with an apparatus comprising a smart water valve device and an energy-generating device, wherein the smart water valve device comprises (i) a controller, (ii) a water valve configured to regulate water flow from a pressurized water source and configured to be operated by the controller, and (iii) a battery configured to power the controller, wherein the energy-generating device is configured to charge the battery based on the water flow from the pressurized water source, the method comprising:
operating, by the controller, the water valve to regulate the water flow from the pressurized water source; and
charging, by the energy-generating device, the battery based on the water flow from the pressurized water source.

15. A non-transitory computer-readable medium comprising instructions that, when executed by a processor, causes an apparatus to perform a set of operations, wherein the apparatus comprises a smart water valve device and an energy-generating device, wherein the smart water valve device comprises (i) a controller, (ii) a water valve configured to regulate water flow from a pressurized water source and configured to be operated by the controller, and (iii) a battery configured to power the controller, wherein the energy-generating device is configured to charge the battery based on the water flow from the pressurized water source, and wherein the set of operations comprises:
operating, by the controller, the water valve to regulate the water flow from the pressurized water source; and
charging, by the energy-generating device, the battery based on the water flow from the pressurized water source.
